# EUROPEAN PATENT SPECIFICATION

(11) **EP 3 333 922 B1**
(45) Date of publication and mention of the grant of the patent: **16.02.2022**
(21) Application number: 15884917.4
(22) Date of filing: 17.12.2015
(51) Int. Cl.: H01L 51/52, H01L 51/56, H01L 27/32

(54) **ORGANIC LUMINESCENCE UNIT AND MANUFACTURING METHOD THEREFOR**
ORGANISCHE LUMINESZENTE EINHEIT SOWIE HERSTELLUNGSVERFAHREN DAFÜR
UNITÉ ÉLECTROLUMINESCENTE ORGANIQUE ET SON PROCÉDÉ DE FABRICATION

(30) Priority: 03.08.2015 CN 201510482988
(43) Date of publication of application: 13.06.2018
(73) Proprietor: BOE Technology Group Co., Ltd., Beijing 100015 (CN)
(72) Inventor: HE, Xiaolong, Beijing 100176 (CN); SHU, Shi, Beijing 100176 (CN); XU, Wei, Beijing 100176 (CN); CAO, Zhanfeng, Beijing 100176 (CN); YAO, Qi, Beijing 100176 (CN)
(74) Representative: Brötz, Helmut
(86) International application number: PCT/CN2015/097728
(87) International publication number: WO 2017/020481

(56) References cited:
- EP-A1- 1 605 732
- CN-A- 105 118 929
- US-A- 5 701 055
- US-A- 6 060 728
- US-A1- 2012 161 167

## Description

### TECHNICAL FIELD

The present disclosure relates to an electrode structure, an organic light emitting unit and a manufacturing method of the organic light emitting unit.

### BACKGROUND

Due to the advantages such as high contrast, wide color gamut, low power consumption, thin thickness and light weight, organic light emitting display devices have drawn wide attentions and are widely applied in the fields such as high-end mobile phone and television.

A method for manufacturing a passive matrix organic light emitting device utilizes cathode separation pillars to pattern the cathode, for example, firstly forming cathode separation pillars on a substrate, then evaporating a metal for cathode to form strip electrodes between the separation pillars. However, a technique for preparing the cathode separation pillars employs an ultraviolet exposing process, which suffers from a high difficulty and is not easy to be controlled, and the material of the cathode separation pillars is a kind of modified negative photoresist, which has relatively high costs. US 2012/161167 A1, US 6 060 728 A, EP 1 605 732 A1 and US 5 701 055 A are related to organic light emitting display devices.

### SUMMARY

A first aspect of the present disclosure provides an organic light-emitting unit according to claim 1.

Preferred exemplary embodiments are defined by dependent claims 2-3. According to claim 4 the present invention provides a manufacturing method of an organic light emitting unit. Preferred exemplary embodiments are defined by dependent claims 5-12.

### BRIEF DESCRIPTION OF THE DRAWINGS

In order to clearly illustrate the technical solutions of the embodiments of the present disclosure, the drawings of the embodiments will be briefly described in the following; it is obvious that the described drawings are only related to some embodiments of the disclosure and thus are not limitative of the present disclosure.
Fig. 1 schematically illustrates a plan view of an electrode structure according to an embodiment not forming part of the claimed invention;
Fig. 2 is a sectional view along line I-I in Fig. 1;
Fig. 3a schematically illustrates a plan view of an organic light emitting unit according to an embodiment of the present disclosure;
Fig. 3b is a sectional view along line II-II in Fig. 3a;
Fig. 4 is a flow diagram of a manufacturing method of an organic light emitting unit according to an embodiment of the present disclosure;
Fig. 5a schematically illustrates a plan view of a substrate of an organic light emitting unit according to an embodiment of the present disclosure;
Fig. 5b is a sectional view along line II-II in Fig. 5a;
Fig. 6a schematically illustrates a plan view of a substrate of an organic light emitting unit according to an embodiment of the present disclosure;
Fig. 6b is a sectional view along line II-II in Fig. 6a;
Fig. 7a schematically illustrates a plan view of a substrate of an organic light emitting unit according to an embodiment of the present disclosure;
Fig. 7b is a sectional view along line II-II in Fig. 7a;
Fig. 8 schematically illustrates a sectional view of a substrate of an organic light emitting unit according to an embodiment of the present disclosure;
Fig. 9 schematically illustrates a sectional view of a substrate of an organic light emitting unit according to an embodiment of the present disclosure;
Fig. 10 schematically illustrates a sectional view of a substrate of an organic light emitting unit according to an embodiment of the present disclosure;
Fig. 11a schematically illustrates a plan view of a substrate of an organic light emitting unit according to an embodiment of the present disclosure;
Fig. 11b is a sectional view along line II-II in Fig. 11a;
Fig. 12 is a scanning electron microscope image of a substrate according to an embodiment of the present disclosure;
Fig. 13 schematically illustrates a sectional view of a substrate of an organic light emitting unit according to another embodiment of the present disclosure;
Fig. 14 schematically illustrates a sectional view of a substrate of an organic light emitting unit according to another embodiment of the present disclosure; and
Fig. 15 schematically illustrates a sectional view of a substrate of an organic light emitting unit according to another embodiment of the present disclosure.

### DETAILED DESCRIPTION

In order to make objects, technical solutions and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise defined, the technical terminology or scientific terminology used herein should have the same meaning as commonly understood by one of ordinary skill in the art to which this disclosure belongs. Likewise, a term "a," "an," or "the" does not indicate limitation in number, but specifies the presence of at least one. A term "comprises," "comprising," "includes," "including", or the like means that an element or article ahead of this term encompasses element(s) or article(s) listed behind this term and its(their) equivalents, but does not preclude the presence of other elements or articles. The phrases "connect", "connected", etc., are not intended to define a physical connection or mechanical connection, but may include an electrical connection, directly or indirectly. "On," "under," "left," "right" or the like is only used to describe a relative positional relationship, and when the absolute position of a described object is changed, the relative positional relationship might also be changed accordingly.

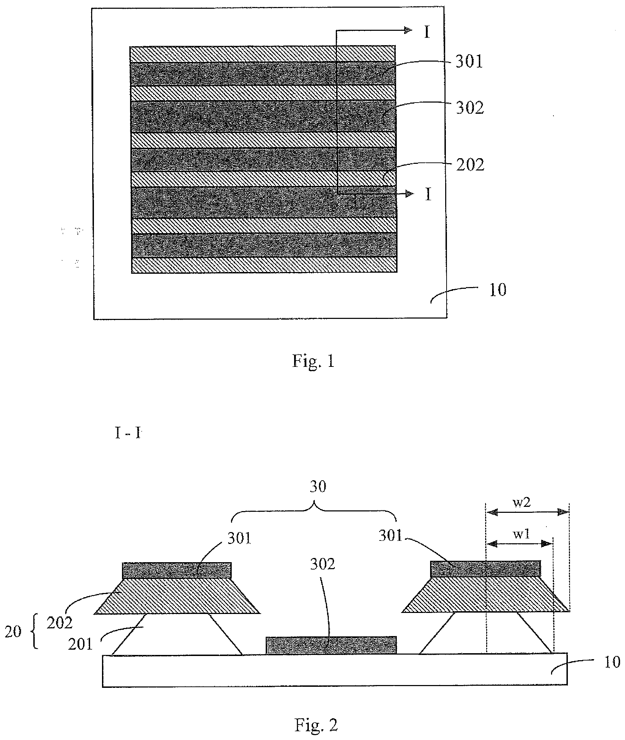

As illustrated by Fig. 1 and Fig. 2, an embodiment not forming part of the claimed invention, provides an electrode structure, comprising: a substrate 10, a plurality of strip-like partitions 20 disposed on the substrate 10, and an electrode 30 covering on a surface of the substrate 10. The electrode 30 comprises a first portion 301 located on a surface of each of the strip-like partitions 20 and a second portion 302 located between two adjacent strip-like partitions 20. Each of the strip-like partitions 20 comprises an upper layer 202 and a lower layer 201 which are stacked with each other, and the upper layer 202 and the lower layer 201 are made of different materials. The bottom surface of the upper layer 202 completely covers the top surface of the lower layer 201, and the width of the bottom surface of the upper layer 202 is larger than the width of the top surface of the lower layer 201 in a plane perpendicular to an extending direction of the strip-like partitions 20.

The plurality of strip-like partitions 20 are disposed in parallel and extend along a horizontal direction in Fig. 1, and Fig. 2 illustrates a sectional view perpendicular to the extending direction in Fig. 1. It can be seen from the drawings that the width of the bottom surface of the upper layer 202 is larger than the width of the top surface of the lower layer 201, so that the first portion 301 can be separated and insulated from the second portion 302. In one example, in order to further ensure that the first portion 301 and the second portion 302 of the electrode 30 are separated from each other, the upper surface of the lower layer 201 can be higher than the upper surface of the second portion 302, for example, higher than the upper surface of the second portion 302 by 600 nm. In Fig. 2, a section formed of a stacked structure of the upper layer 202 and the lower layer 201 are in axial symmetry. In some embodiments, the maximum width w2 on a side of the upper layer 202 is larger than the maximum width w1 on the same side of the lower layer 201 by from 1 µm - 2 µm. However, in other embodiments of the present disclosure, the stacked structure may not be in axial symmetry, for example, the center of the lower layer 201 may be shifted by a certain distance with respect to the center of the upper layer 202, as long as the bottom surface of the upper layer can completely cover the top surface of the lower layer. In this case, the width of the bottom surface of the upper layer 202 may be larger than that of the bottom surface of the lower layer 201 by from 2 µm - 4 µm. In an ideal situation, the section of each layer shall have a rectangle shape; however, due to the influence of an actual etching process, the actual section of each layer generally has a trapezoid shape.

In an example, one of the upper layer 202 and the lower layer 201 is made of a resin material, and the other one is made of an inorganic insulating material. For example, the layer made of an inorganic insulating material has a thickness of 0.2 µm - 1 µm, and if the layer made of an inorganic insulating material is too thin, the strength is not enough; if the layer made of an inorganic insulating material is too thick, there will be production capacity and thin film stress problems; and the thickness may be 0.4 µm - 0.6 µm. In an example, the layer made of a resin material has a thickness of 1 µm - 3 µm, and if the layer made of a resin material is too thin, the isolation effect is bad; if the layer made of a resin material is too thick, there will be material waste and thin film stress problems, and the thickness may be 1.5 µm-2 µm.

In an example, the upper layer 202 may be made of an inorganic insulating material, such as: SiNx, SiOx, SiON, AlOx, and thus has high strength; even after being spin-coated and then being edged, the upper layer will not be damaged; the lower layer 201 may be made of a resin material, for example, a thermal curing resin or a light-curable resin, comprising conventional positive or negative photoresist, epoxy resin or the like, these materials have temperature tolerance above 130□, have certain mechanical strength, and have a good isolation effect.

In another example, the upper layer 202 may be made of a resin material, and the lower layer 201 may be made of an inorganic insulating material. In this case, in order to conveniently manufacture the strip-like partitions, the resin material may be photosensitive resin, so that it can be used as a mask after being patterned. The specific examples of the inorganic insulating material may refer to the above examples.

In the present embodiment, the strip-like partition adopts a two-layer structure composed of an inorganic insulating layer and a resin layer, which not only improves the mechanical strength but also facilitates insulation between two portions (a first portion 301 and a second portion 302) of the electrode 30, so as to avoid short circuit and improve the stability of the electrode structure. The strip-like partition may be widely applied in the display technical field, especially in manufacturing electrode patterns, which are insulated from each other, on a substrate. Hereafter, the case where the strip-like partition is applied in an organic light emitting unit is described as an example, but the scope of the present disclosure is not limited thereto.

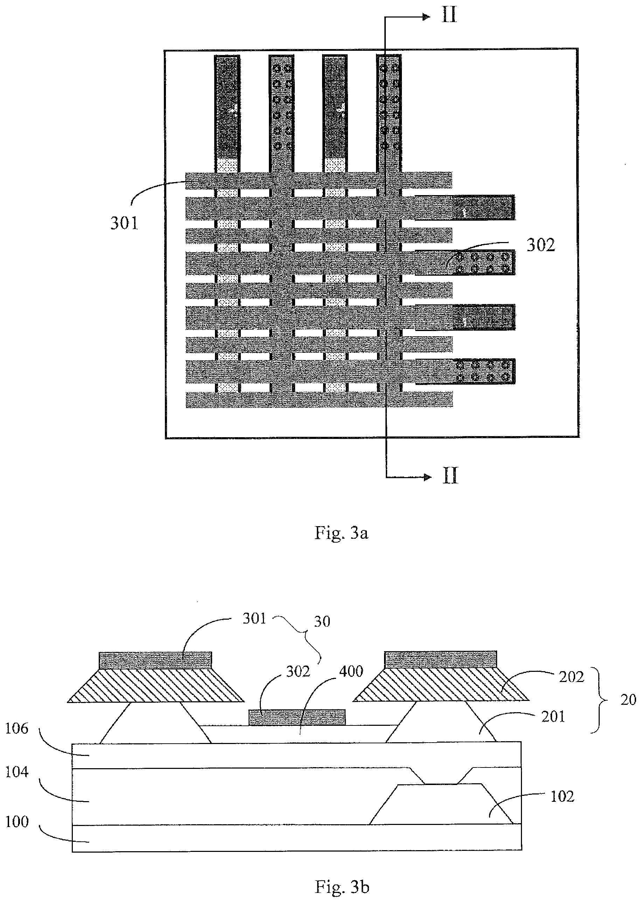

As illustrated by Fig. 3a and Fig. 3b, an embodiment according to the claimed invention provides an organic light emitting unit, which comprises: a base substrate 100; a metal electrode 102, an interlayer dielectric layer 104, and a first electrode 106 which are sequentially disposed on the base substrate 100; a plurality of strip-like partitions 20 disposed on the first electrode 106; and an organic light emitting layer 400 disposed between two adjacent strip-like partitions 20. The organic light emitting unit further comprises a second electrode 30 covering a surface of the substrate, the second electrode 30 comprises a first portion 301 located on a surface of each of the strip-like partitions and a second portion 302 located on the organic light emitting layer 400. Each of the strip-like partitions 20 comprises a first material layer located in the lower layer 201 and a second material layer located in the upper layer 202. The first material layer and the second material layer are made of different materials. One of the first material layer and the second material layer is made of a resin material, and the other layer is made of an inorganic insulating material. The bottom surface of the upper layer 202 completely covers the top surface of the lower layer 201, and a width of the bottom surface of the upper layer 202 is larger than that of the top surface of the lower layer 201, in this way the first portion 301 and the second portion 302 of the second electrode 30 are separated and insulated from each other.

In the present embodiment, the configuration, material and thickness of the strip-like partitions 20 are as defined in claim 1 Unlike the abovementioned embodiments, the present embodiment disposes a plurality of function layers on the base substrate 100, which comprise a metal electrode 102, an interlayer dielectric layer 104, a first electrode 106, and an organic light emitting layer 400. Herein, for example, the base substrate 100 may adopt a glass substrate, a quartz substrate, a plastic substrate or other transparent substrate. The metal electrode 102 may be made of a metal material or an alloy material. The interlayer dielectric layer 104 may be made of an insulating material, such as SiOx and SiNx. The interlayer dielectric layer 104 is provided with a via hole therein, and the first electrode 106 is electrically connected with the metal electrode 102 through the via hole.

In the present embodiment, the first electrode 106 serves as a cathode, the second electrode 30 serves as an anode, and the organic light emitting layer 400 is sandwiched between the cathode and the anode. It can be understood that the structure of the organic light emitting unit illustrated in Fig. 3b is only schematic, in the other embodiments of the present disclosure, the metal electrode 102 and the interlayer dielectric layer 104 may be omitted. Besides, a hole injection layer, a hole transport layer, an electron injection layer, an electron transport layer and the like can be additionally disposed between the cathode 105 and the anode 30, so as to further improve the performance of the organic light emitting unit.

In the present embodiment, the cathode partition of the organic light emitting unit adopts a two-layer structure composed of an inorganic insulating layer and a resin layer, which not only improves the mechanical strength, but also conveniently insulate the two portions (the first portion 301 and the second portion 302) of the second electrode from each other, so as to avoid short circuit and improve the stability of the cathode.

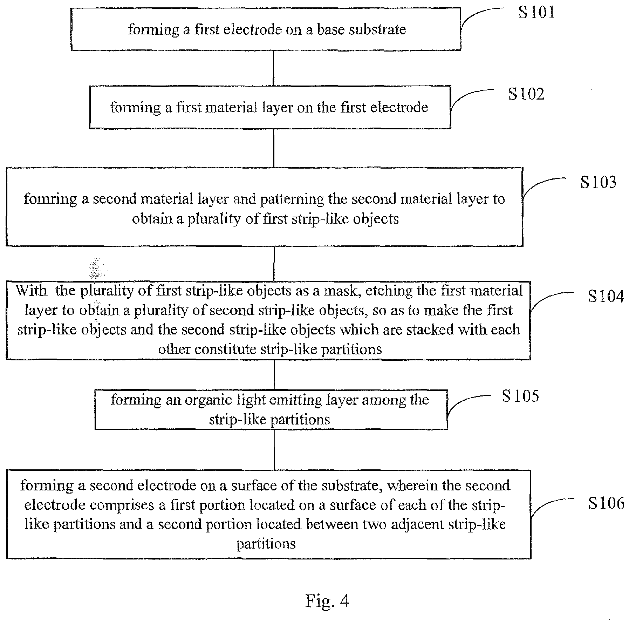

Yet another embodiment according to the present disclosure provides a manufacturing method of an organic light emitting unit, as illustrated by Fig. 4, the method comprises the following steps:
S101: forming a first electrode on a base substrate;
S102: forming a first material layer on the first electrode;
S103: forming a second material layer on the first material layer and then patterning the second material layer to obtain a plurality of first strip-like members;
S104: etching the first material layer with the plurality of first strip-like members as a mask to obtain a plurality of second strip-like members, whereby each of the first strip-like members and each of the second strip-like members which are stacked with each other constitute a strip-like partition;
S105: forming an organic light emitting layer among the plurality of strip-like partitions; and
S106: forming a second electrode on a surface of the substrate, wherein the second electrode comprises a first portion located on a surface of each of the strip-like partitions and a second portion located on a surface of the organic light emitting layer; the first material layer and the second material layer are made of different materials; a width of a bottom surface of the second material layer is larger than that of a top surface of the first material layer, and the bottom surface of the second material layer completely covers the top surface of the first material layer. In the present application, the expression "a width of the bottom surface of the second material layer is larger than a width of the top surface of the first material layer" or similar expressions refers to, as for each of the strip-like partitions, the width of the bottom surface of the second material layer is larger than the width of the top surface of the first material layer.

In an example, in order to manufacture the organic light emitting unit illustrated by Fig. 3b, the step S101 may further comprise: before forming the first electrode 106, forming a metal electrode 102 and a interlayer dielectric layer 104 on the base substrate 100, wherein the interlayer dielectric layer 104 is provided with a via hole therein, such that the first electrode 106 can be electrically connected with the metal electrode 102 through the via hole.

Hereafter, the manufacturing method of an organic light emitting unit will be further described by taking the case where the lower layer of strip-like partition 20 in the organic light emitting unit in Fig. 3b is a resin layer and the upper layer is an inorganic insulating layer as an example.

Another embodiment according to the present disclosure provides a manufacturing method, comprising the following steps:
S201: sequentially forming a metal electrode 102, an interlayer dielectric layer 104 and a first electrode 106 on a base substrate 100, wherein the interlayer dielectric layer 104 is provided with a via hole therein, the metal electrode 102 is electrically connected with the first electrode 106 through the via hole.

In an example, the step S201 may comprise the following steps S201a - S201e.

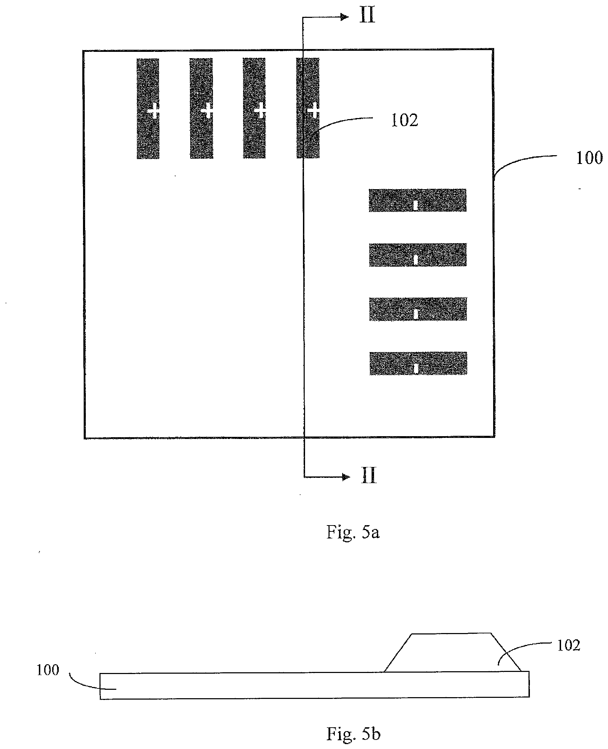

S201a: forming a metal thin film on a base substrate 100, and patterning the metal thin film to form a plurality of metal electrodes 102 through a patterning process, as illustrated by Fig. 5a and Fig. 5b.

Fig. 5a schematically illustrates a plan view of a substrate according to an embodiment of the present disclosure, and Fig. 5b is a sectional view along line II-II in Fig. 5a. For example, the metal thin film may be formed on the base substrate 100 by using a conventional depositing technology, for example, a sputtering process, a plasma enhanced chemical vapor deposition (PECVD) process, or an evaporation process. The metal thin film can adopt a metal or an alloy, comprising, but not limited to, molybdenum, aluminum, cuprum, titanium, neodymium or other metal or any alloy thereof. For example, the base substrate 100 may adopt a glass substrate, a quartz substrate, a plastic substrate or other transparent substrates. The metal electrode 102 has a long strip shape, comprising a plurality of positive electrodes extending along a vertical direction and a plurality of negative electrodes extending along a horizontal direction. The positive electrode is configured to import a gate electrode signal (positive voltage), for example, applied with a positive level, injecting holes into the organic light emitting layer through a hole injection layer and a hole transport layer; the negative electrode is configured to import a data signal (negative voltage), applied with a negative level, injecting electrons into the organic light emitting layer through an electron injection layer and an electron transport layer; and thus the light emitting layer can be driven to emit light. The "patterning process" in the text typically comprises the steps such as coating photoresist, exposing, developing, etching, and stripping. In order to form a specific pattern, a half tone mask plate or a gray tone mask plate may be used during the patterning process.

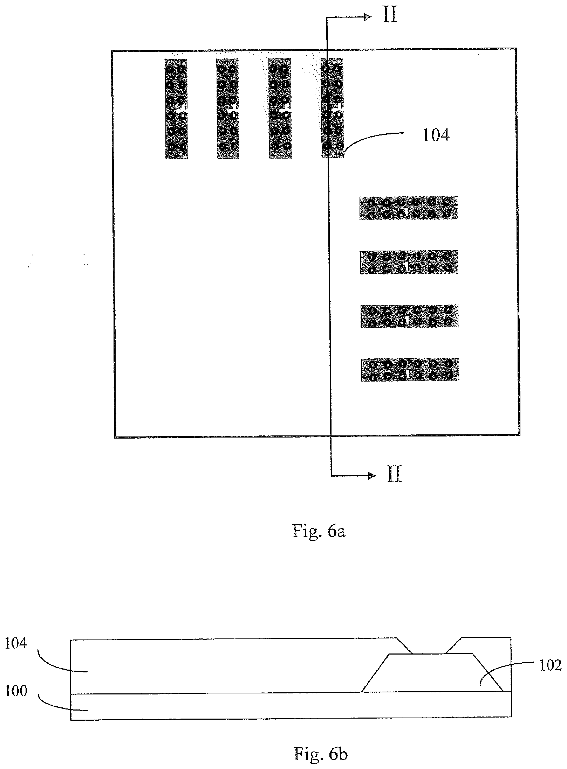

S201b: forming an inorganic material thin film on the plurality of metal electrodes 102, and patterning the inorganic insulating thin film through a patterning process to form an interlayer dielectric layer 104 covering each of the metal electrodes, wherein the interlayer dielectric layer 104 is provided with a plurality of via holes, as illustrated by Figs. 6a and 6b, and Fig. 6b only illustrates one via hole as an example.

For example, the interlayer dielectric layer 104 is made of an inorganic insulating material, for example, SiOx, SiNx or SiON.

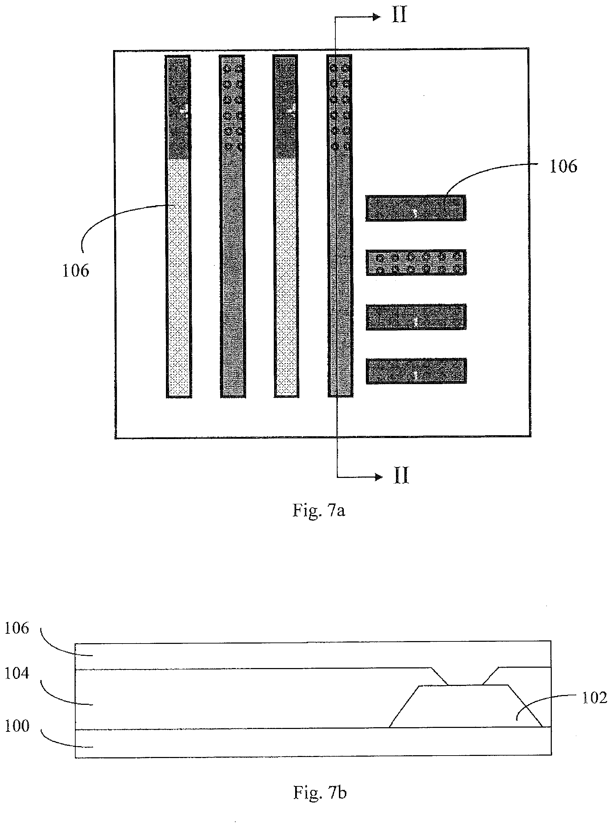

S201c: forming a transparent conductive thin film on the interlayer dielectric layer 104, and patterning the transparent conductive thin film through a patterning process to form a plurality of first electrodes 106, as illustrated by Figs. 7a and 7b.

For example, the transparent conductive thin film may adopt ITO (Indium tin oxide), IZO (Indium zinc oxide) or other transparent conductive material. The first electrodes 106 cover both the positive electrodes and the negative electrodes, wherein the first electrodes 106 on the positive electrodes arc extended as strip electrodes, perpendicular to an extending direction of the plurality of negative electrodes, and are configured to import a positive electrode signal; the first electrodes 106 on the negative electrodes only cover rightly on the electrode, and are configured to connect the evaporated negative metal, and import a negative electrode signal

The abovementioned manufacturing method of an organic light emitting unit further comprises the following steps.

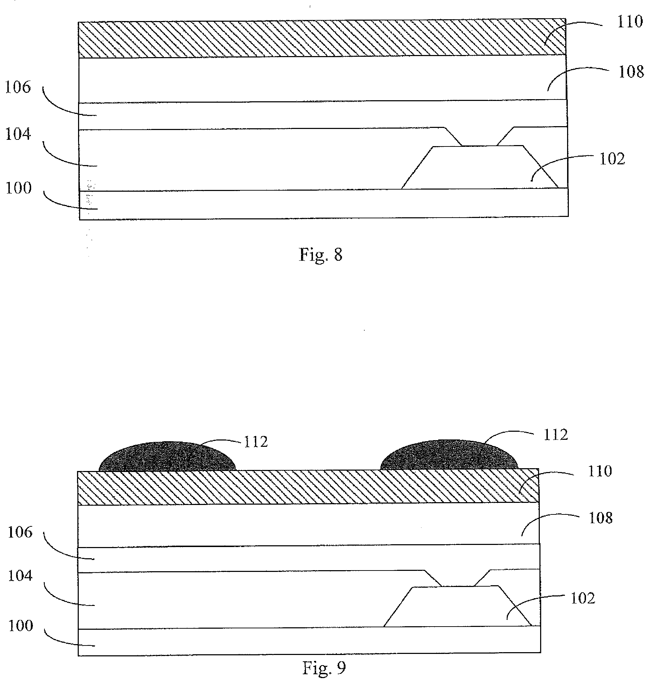

S202: forming a resin thin film 108 used for forming the first material layer on the first electrode 106, then forming an inorganic insulating thin film 110 used for forming the second material layer on the resin thin film 108, as illustrated by Fig. 8.

For example, a drop coating method is used to coat resin liquid on the first electrode. The resin liquid may be thermal curing resin or light-curable resin, and then thermally curing or curing with light the resin liquid to form a resin thin film 108. Because the abovementioned resin is conventional positive or negative photoresist, epoxy resin or the like, these materials have temperature tolerance above 130□, have certain mechanical strength, and have good isolation effect and low costs. Afterwards, an inorganic insulating thin film 110 is disposed on the resin thin film 108 through a PECVD method. The inorganic insulating thin film employs an inorganic insulating material, for example, SiNx, SiOx, SiON or AlOx, and thus has high strength; even after being spin-coated and then edged, the inorganic insulating thin film will not be damaged.

The inorganic insulating thin film 110 has a thickness of 0.2 µm - 1 µm, and if this thin film made of an inorganic insulating material is too thin, the strength is not enough, and if this thin film is too thick, there will be production capacity and thin film stress problems. In some embodiments; the thickness thereof may be 0.4 µm - 0.6 µm. In an example, a resin material thin film has a thickness of 1 µm - 3 µm, if this thin film of the resin material is too thin, the isolation effect is bad, and if this thin film of the resin material is too thick, there will be material waste and thin film stress problems, and, in the present invention, the thickness thereof is 1.5 µm - 2 µm.

S203: forming photoresist 112 on an inorganic insulating thin film 110, and patterning the photoresist 112 through exposing and developing processes to expose a part of the inorganic insulating thin film, as illustrated by Fig. 9.

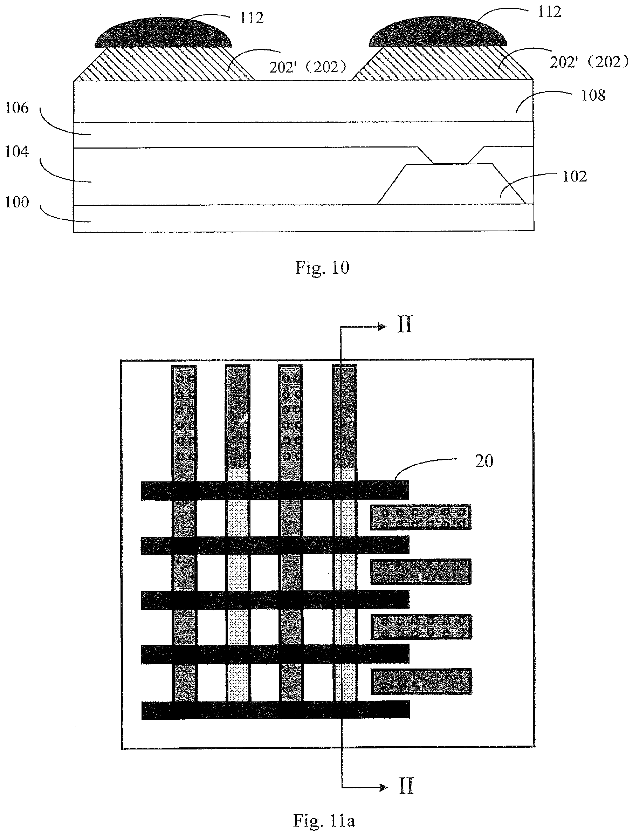

S204: etching the exposed part of the inorganic insulating thin film through a dry etching method to form a plurality of first strip-like members 202' made of an inorganic insulating material (i.e., an upper layer 202 in Fig. 3), as illustrated by Fig. 10.

For example, in the dry etching process, the etching gas adopts a mixed gas of fluoride-containing gas and oxygen. For example, the fluoride-containing gas may be SF6 or CF4, the gas flow may be 50 sccm - 800 sccm, for example, the gas flow may be 350 - 400 sccm; if the gas flow is too low, the etching rate is relatively slow and not convenient for mass production; if the gas flow is too high, the evenness is relatively bad. For example, the gas flow of oxygen may be 0 - 300 sccm, or 100 sccm - 150 sccm, whose function is mainly used to increase the etching rate to some degree. In one example, the etching gas may comprise helium (He), for example, its gas flow may be 0 - 200 sccm, which can increase the etching evenness to some degree. For example, the etching power is 200W - 800W, and the etching rate is generally 50Å - 300Å, for example, 150Å - 200 Å, so as to improve the efficiency, and too high speed will cause bad evenness. The etching time is 20 seconds to 400 seconds, and too long etching time will cause overheat of the substrate and generate deformation.

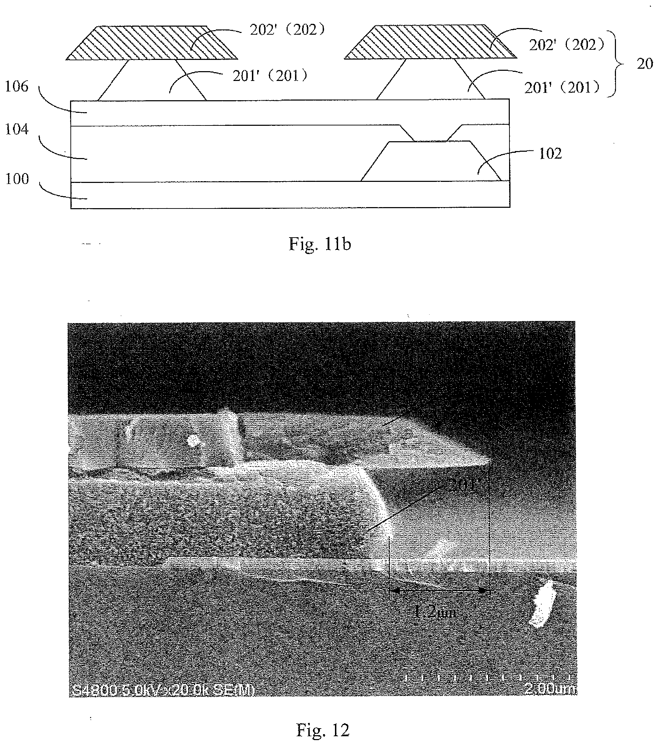

S205: with the plurality of first strip-like members 202' as a mask, treating the resin thin film 108 through an ashing process to simultaneously remove a part of the resin thin film and the residual photoresist, so as to obtain a plurality of second strip-like members 201' (a lower layer 201 in Fig. 3) made of the resin material, as illustrated by Figs. 11a and 11b. The first strip-like member 202' and the second strip-like member 201' constitute the strip-like partitions 20.

For example, in the ashing process, oxygen plasma can be utilized to ash the resin thin film, so as to avoid damaging the first strip-like members 202', and can simultaneously remove the residual photoresist remained on the first strip-like members 202'. The ashing time can be determined according to the thickness of the resin thin film to be removed and the expected width of the second strip-like members 201'. In the present embodiment, the ashing time is about 100 seconds to 200 seconds, for example, 150 seconds. At the interface where the first strip-like member 202' contacts the second strip-like member 201', the width of the first strip-like member 202' is larger than the width of the second strip-like member 201', such that it can be guaranteed that the metal electrode is broken at the strip-like partitions 20 when the metal electrode is evaporated in the subsequent step. In some embodiments, a maximum width of a side of the first strip-like member 202' is larger than that of the second strip-like member 201' at the same side, for example by 1 µm - 2 µm. Fig.12 is the scanning electron microscope (SEM) picture of the substrate after the step S205 is completed. From the picture, it can be seen that the maximum width of a side of the first strip-like member 202' is larger than that of the second strip-like member 201' at the same side, for example, by 1.2 µm from measure. In some embodiments, the maximum widths of the first strip-like member 202' at the two sides thereof are respectively larger than those of the second strip-like member 201' at the same two sides by 1 µm - 2 µm.

S206: forming an organic light emitting layer 400 among the plurality of strip-like partitions 20.

The organic light emitting layer 400 is deposited in the interspaces among the strip-like partitions through an evaporation method, the organic light emitting layer adopts small molecules for OLED or a quantum dot material, because these materials have isotropy, the organic light emitting layer is separately physically contacted with the second strip-like members 201' located at two sides of the organic light emitting layer.

S207: forming a second electrode 30 on a surface of the substrate, the second electrode 30 comprises a first portion 301 located on the surface of each of the strip-like partitions 20 and a second portion 302 located on the surface of the organic light emitting layer, as illustrated by Figs. 3a and 3b.

For example, a second electrode is formed on the surface of the substrate through an evaporation method, and the metal may be one or more selected from a group consisting of magnesium, argentums and aluminum. Because the width of the first strip-like members 202' is larger than that of the second strip-like members 201', the first portion 301 and the second portion 302 of the second electrode 30 are broken due to the uncontinuous interface between the first strip-like member 202' and the second strip-like member 201', and are separated and insulated from each other. In the present embodiment, the first electrode 106 serves as a cathode, the second electrode 30 serves as an anode, and the organic light emitting layer 400 is sandwiched between the cathode and the anode.

In the present embodiment, the cathode of the organic light emitting unit is in a two-layer structure composed of a resin layer/an inorganic insulating layer, which not only improves the mechanical strength, but also facilitates to insulate the two electrode portions (the first portion 301 and the second portion 302) from each other, so as to avoid short circuit, and improve the stability of the cathode.

Another embodiment according to the present disclosure provides a manufacturing method of an organic light emitting unit, unlike the abovementioned embodiments, in the present embodiment, the lower layer of the strip-like partitions 20 is an inorganic insulating layer, and the upper layer is a resin layer. The method comprises the following steps:
S301: same as step S201.

In one example, step S301 may comprise S201a-S201c, as illustrated by Figs. 5a-7b.

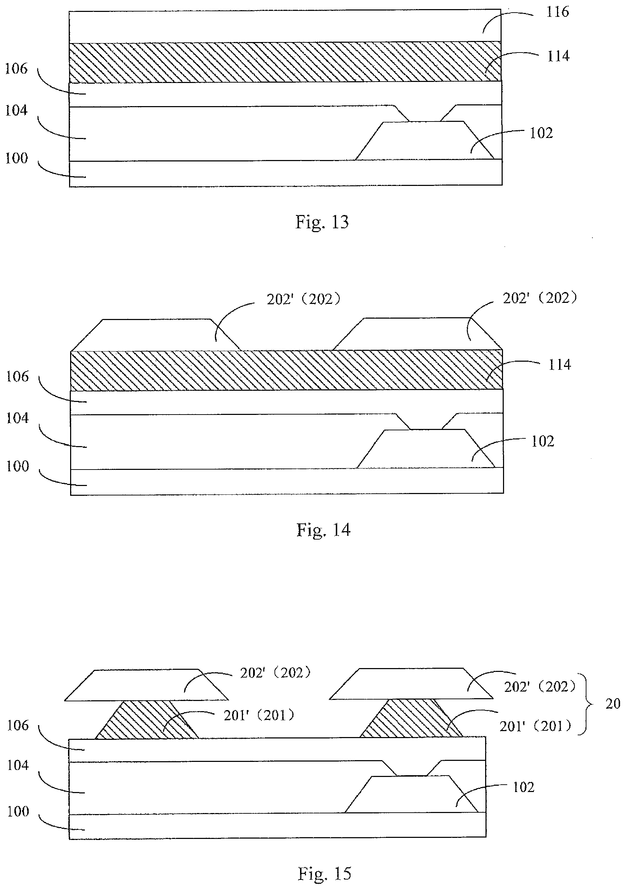

S302: forming an inorganic insulating thin film 114 used for forming the first material layer on the first electrode 106, then forming a resin thin film 116 used for forming the second material layer on the inorganic insulating thin film, as illustrated by Fig. 13; then, patterning the resin thin film 116 through exposing and developing processes to obtain a plurality of first strip-like members 202' made of a resin material and expose a part of the inorganic insulating thin film, as illustrated by Fig. 14.

S303: with the plurality of first strip-like members 202' as a mask, etching the exposed inorganic insulating thin film 114 through a dry etching process to obtain a plurality of second strip-like members 201' made of the inorganic insulating material, as illustrated by Fig. 15. The first strip-like members 202' and the second strip-like members 201' constitute the strip-like partitions 20.

In the dry etching process, the etching gas(es) is the same as the abovementioned embodiments.

S304: same as step S206.

S305: same as step S207.

In the present embodiment, the inorganic insulating thin film 114 has the same material and thickness as the inorganic insulating thin film 110 in the abovementioned embodiments. However, the resin thin film in the present embodiment adopts photosensitive resin, such as DPI - 1000, which is more favorable for serving as a mask and reduces the costs. The forming process of the thin film is same as the abovementioned embodiments. Because the width of the first strip-like members 202' is larger than that of the second strip-like members 201', the first portion 301 and the second portion 302 of the second electrode 30 are separated and insulated with each other.

In the present embodiment, the cathode of the organic light emitting unit adopts a two-layer structure made of an inorganic insulating layer/a resin layer, which not only improves the mechanical strength, but also facilitates to insulate two electrode portions (the first portion 301 and the second portion 302) form each other, so as to avoid short circuit and improve the stability of the cathode.

The organic light emitting layer in the organic light emitting unit provided by the embodiments of the present disclosure may be any kind of electroluminescence layer, thus, the embodiments of the present disclosure also relate to an electroluminescence unit. Besides, the embodiments of the present disclosure further provide a display apparatus comprising the organic light emitting unit or electroluminescence unit.

## Claims

1. An organic light emitting unit, comprising:
a base substrate (10);
a first electrode (106) disposed on the base substrate (10);
a plurality of strip-like partitions (20) disposed on the first electrode (106);
an organic light emitting layer (400) disposed between two adjacent strip-like partitions (20); and
a second electrode (30) covering a surface of the base substrate (10), wherein the second electrode (30) comprises a first portion (301) located on a surface of each of the strip-like partitions (20) and a second portion (302) located between two adjacent strip-like partitions (20),
wherein each of the strip-like partitions (20) comprises a first material layer located at an lower layer (201) and a second material layer located at an upper layer (202), the first material layer and the second material layer are made of different materials; a bottom surface of the upper layer (202) completely covers a top surface of the lower layer (201), and a width of the bottom surface of the upper layer (202) is larger than a width of the top surface of the lower layer (201) in a plane perpendicular to an extending direction of the strip-like partitions (20),
**characterized in that** one of the second material layer and the first material layer is made of a resin material, and other one is made of an inorganic insulating material; a thickness of the layer made of the resin material is 1.5µm to 2µm and a thickness of the layer made of the inorganic insulating material is 0.2 µm to 1 µm, and
the organic light emitting layer is separately physically contacted with the first material layers located at two sides of the organic light emitting layer.

2. The organic light emitting unit according to claim 1, wherein an upper surface of the lower layer (201) is higher than an upper surface of the second portion (302) of the second electrode (30).

3. The organic light emitting unit according to any one of claims 1-2, wherein a section of a stacked layer constitued by the upper layer (202) and the lower layer (201) is in axial symmetry in the plane perpendicular to an extending direction of the strip-like partitions (20).

4. A manufacturing method of an organic light emitting unit, comprising:
forming a first electrode (106) on a base substrate (10);
forming a first material layer on the first electrode (106);
fomring a second material layer and patterning the second material layer to obtain a plurality of first strip-like members;
etching the first material layer by way of the plurality of first strip-like members as a mask to obtain a plurality of second strip-like members, so as to allow the first strip-like members and the second strip-like members which are stacked with each other constitute strip-like partitions (20);
forming an organic light emitting layer (400) among the strip-like partitions (20); and
forming a second electrode (30) on a surface of the base substrate (10), wherein the second electrode (30) comprises a first portion (301) located on a surface of each of the strip-like partitions (20) and a second portion (302) located between two adjacent strip-like partitions (20),
wherein the first material layer and the second material layer are made of different materials; in a plane perpendicular to an extending direction of the strip-like partitions (20), a width of a bottom surface of the second material layer is larger than a width of a top surface of the first material layer, and the bottom surface of the second material layer completely covers the top surface of the lower layer (201),
**characterized in that** one of the second material layer and the first material layer is made of a resin material, and other one is made of an inorganic insulating material; a thickness of the layer made of the resin material is 1.5µm to 2 µm, and a thickness of the layer made of the inorganic insulating material is 0.2 µm to 1µm, and
the organic light emitting layer is separately physically contacted with the first material layers located at two sides of the organic light emitting layer.

5. The method according to claim 4, wherein the first material layer is made of a resin material, and the second material layer is made of an inorganic insulating material.

6. The method according to claim 5, further comprising:
forming a resin thin film (108) used for the first material layer, and then forming an inorganic insulating thin film (110) used for the second material layer on the resin thin film (108);
forming photoresist (112) on the inorganic insulating thin film (110), and patterning the photoresist through exposing and developing processes to expose a part of the inorganic insulating thin film (110); and
etching the exposed part of the inorganic insulating thin film (110) through a dry etching process to obtain the plurality of first strip-like members (202') made of the inorganic insulating material.

7. The method according to claim 6, further comprising:
with the plurality of first strip-like members (202') as a mask, treating the resin thin film (108) through an ashing process to simultaneously remove a part of the resin thin film (108) and residual photoresist (112), so as to obtain the plurality of second strip-like members (201') made of the resin material.

8. The method according to claim 7, wherein in the ashing process, an ashing gas is an oxygen plasma.

9. The method according to claim 4, wherein the first material layer is made of an inorganic insulating material, and the second material layer is made of a resin material.

10. The method according to claim 9, further comprising:
forming an inorganic insulating thin film (114) used for the first material layer, and then forming a resin thin film (116) used for the second material layer on the inorganic insulating thin film (114); and
patterning the rein thin film (116) through exposure and development processes to obtain the plurality of first strip-like members (202') made of the resin material and expose a part of the inorganic insulating thin film (114).

11. The method according to claim 10, further comprising:
with the plurality of first strip-like members (202') as a mask, ething the exposed inorganic insulating thin film (114) to obtain the plurality of second strip-like members (201') made of the inorganic insulating material.

12. The method according to any one of claims 9-11, wherein the resin material is photosensitive resin.

## Patentansprüche

1. Organische Licht emittierende Einheit, umfassend:
ein Basissubstrat (10);
eine erste Elektrode (106), angeordnet auf dem Basissubstrat (10);
eine Mehrzahl von streifenartigen Teilbereichen (20), angeordnet auf der ersten Elektrode (106);
eine organische Licht emittierende Schicht (400), angeordnet zwischen zwei benachbarten streifenartigen Teilbereichen (20); und
eine zweite Elektrode (30), die eine Oberfläche des Basissubstrats (10) bedeckt, wobei die zweite Elektrode (30) einen ersten Bereich (301), der auf einer Oberfläche von jedem der streifenartigen Teilbereiche (20) lokalisiert ist, und einen zweiten Bereich (302), der zwischen zwei benachbarten streifenartigen Teilbereichen (20) lokalisiert ist, umfasst,
wobei jeder der streifenartigen Teilbereiche (20) eine erste Materialschicht, lokalisiert bei einer unteren Schicht (201), und eine zweite Materialschicht, lokalisiert bei einer oberen Schicht (202), umfasst, wobei die erste Materialschicht und die zweite Materialschicht aus verschiedenen Materialien hergestellt sind; eine untere Oberfläche der oberen Schicht (202) bedeckt vollständig eine obere Oberfläche der unteren Schicht (201), und eine Breite der unteren Oberfläche der oberen Schicht (202) ist größer als eine Breite der oberen Oberfläche der unteren Schicht (201) in einer Ebene senkrecht zu einer Erstreckungsrichtung der streifenartigen Teilbereiche (20),
**dadurch gekennzeichnet, dass** eine von der zweiten Materialschicht und der ersten Materialschicht aus einem Harzmaterial hergestellt ist und die andere aus einem anorganischen Isoliermaterial hergestellt ist; wobei eine Dicke der aus dem Harzmaterial hergestellten Schicht 1,5 µm bis 2 µm beträgt und wobei eine Dicke der aus dem anorganischen Isoliermaterial hergestellten Schicht 0,2 µm bis 1 µm beträgt, und wobei die organische Licht emittierende Schicht separat technisch mit den ersten Materialschichten, die auf zwei Seiten der organischen Licht emittierenden Schicht angeordnet sind, kontaktiert ist.

2. Organische Licht emittierende Einheit gemäß Anspruch 1, wobei eine obere Oberfläche der unteren Schicht (201) höher als eine obere Oberfläche des zweiten Bereichs (302) der zweiten Elektrode (30) ist.

3. Organische Licht emittierende Einheit gemäß einem der Ansprüche 1-2, wobei ein Abschnitt einer gestapelten Schicht, gebildet mittels der oberen Schicht (202) und der unteren Schicht (201), in axialer Symmetrie ist in der Ebene senkrecht zu einer Erstreckungsrichtung der streifenartigen Teilbereiche (20).

4. Herstellungsverfahren für eine organische Licht emittierende Einheit, umfassend:
Bilden einer ersten Elektrode (106) auf einem Basissubstrat (10);
Bilden einer ersten Materialschicht auf der ersten Elektrode (106);
Bilden einer zweiten Materialschicht und Bemusterung der zweiten Materialschicht, um eine Mehrzahl von ersten streifenartigen Teilen zu erhalten;
Ätzen der ersten Materialschicht mittels der Mehrzahl von ersten streifenartigen Teilen als eine Maske, um eine Mehrzahl von zweiten streifenartigen Teilen zu erhalten, um es den ersten streifenartigen Teilen und zweiten streifenartigen Teilen, die miteinander gestapelt sind, zu erlauben, streifenartige Teilbereiche (20) zu bilden;
Bilden einer organischen Licht emittierenden Schicht (400) zwischen den streifenartigen Teilbereiche (20); und Bilden einer zweiten Elektrode (30) auf einer Oberfläche des Basissubstrats (10), wobei die zweite Elektrode (30) einen ersten Bereich (301), lokalisiert auf einer Oberfläche von jedem der streifenartigen Teilbereiche (20), und einen zweiten Bereich (302), lokalisiert zwischen zwei benachbarten streifenartigen Teilbereiche (20), umfasst,
wobei die erste Materialschicht und die zweite Materialschicht aus verschiedenen Materialien hergestellt werden; wobei in einer Ebene senkrecht zu einer Erstreckungsrichtung der streifenartigen Teilbereiche (20) eine Breite von einer unteren Oberfläche der zweiten Materialschicht größer ist als eine Breite von einer oberen Oberfläche der ersten Materialschicht, und die untere Oberfläche der zweiten Materialschicht die obere Oberfläche der unteren Schicht (201) vollständig bedeckt,
**dadurch gekennzeichnet, dass** eine von der zweiten Materialschicht und der ersten Materialschicht aus einem Harzmaterial hergestellt wird und die andere aus einem anorganischen Isoliermaterial hergestellt wird, wobei eine Dicke der aus dem Harzmaterial hergestellten Schicht 1,5 µm bis 2 µm beträgt und eine Dicke der aus dem anorganischen Isoliermaterial hergestellten Schicht 0,2 µm bis 1 µm beträgt, und wobei die organische Licht emittierende Schicht separat technisch kontaktiert wird mit den ersten Materialschichten, die an zwei Seiten der organischen Licht emittierenden Schicht lokalisiert sind.

5. Verfahren gemäß Anspruch 4, wobei die erste Materialschicht aus einem Harzmaterial hergestellt wird und die zweite Materialschicht aus einem anorganischen Isoliermaterial hergestellt wird.

6. Verfahren gemäß Anspruch 5, außerdem umfassend:
Bilden eines Harzdünnfilms (108), verwendet für die erste Materialschicht, und dann Bilden eines anorganischen Isolierdünnfilms (110), verwendet für die zweite Materialschicht auf dem Harzdünnfilm (108);
Bilden von Photoresist (112) auf dem anorganischen Isolierdünnfilm (110), und Bemusterung des Photoresists durch Belichtungs- und Entwicklungsprozesse, um einen Teil des anorganischen Isolierdünnfilms (110) freizulegen; und
Ätzen des freigelegten Teils des anorganischen Isolierdünnfilms (110) durch einen Trockenätzprozess, um die Mehrzahl von ersten streifenartigen Teilen (202'), hergestellt aus dem anorganischen Isoliermaterial, zu erhalten.

7. Verfahren gemäß Anspruch 6, außerdem umfassend:
mit der Mehrzahl von ersten streifenartigen Teilen (202') als eine Maske Behandeln des Harzdünnfilms (108) durch einen Veraschungsprozess, um simultan einen Teil des Harzdünnfilms (108) und verbleibendes Photoresists (112) zu entfernen, um die Mehrzahl von zweiten streifenartigen Teilen (201'), hergestellt aus dem Harzmaterial, zu erhalten.

8. Verfahren gemäß Anspruch 7, wobei in dem Veraschungsprozess ein Veraschungsgas ein Sauerstoffplasma ist.

9. Verfahren gemäß Anspruch 4, wobei die erste Materialschicht aus einem anorganischen Isoliermaterial hergestellt wird und die zweite Materialschicht aus einem Harzmaterial hergestellt wird.

10. Verfahren gemäß Anspruch 9, außerdem umfassend:
Bilden eines anorganischen Isolierdünnfilms (114), verwendet für die erste Materialschicht, und dann Bilden eines Harzdünnfilms (116), verwendet für die zweite Materialschicht auf dem anorganischen Isolierdünnfilm (114); und
Bemustern des Harzdünnfilms (116) durch Belichtungs- und Entwicklungsprozesse, um die Mehrzahl von ersten streifenartigen Teilen (202'), hergestellt aus dem Harzmaterial, zu erhalten und
Freilegen eines Teils des anorganischen Isolierdünnfilms (114).

11. Verfahren gemäß Anspruch 10, außerdem umfassend:
mit der Mehrzahl von ersten streifenartigen Teilen (202') als eine Maske Ätzen des freigelegten anorganischen Isolierdünnfilms (114), um die Mehrzahl von zweiten streifenartigen Teilen (201'), hergestellt aus dem anorganischen Isoliermaterial, zu erhalten.

12. Verfahren gemäß einem der Ansprüche 9-11, wobei das Harzmaterial ein photosensitives Harz ist.

## Revendications

1. Unité électroluminescente organique, comprenant :
un substrat de base (10) ;
une première électrode (106) disposée sur le substrat de base (10) ;
une pluralité de séparations de type bande (20) disposées sur la première électrode (106) ;
une couche électroluminescente organique (400) disposée entre deux séparations de type bande (20) adjacentes ; et
une seconde électrode (30) couvrant une surface du substrat de base (10), dans laquelle la seconde électrode (30) comprend une première partie (301) située sur une surface de chacune des séparations de type bande (20) et une seconde partie (302) située entre deux séparations de type bande (20) adjacentes,
dans laquelle chacune des séparations de type bande (20) comprend une première couche de matériau située à une couche inférieure (201) et une seconde couche de matériau située à une couche supérieure (202), la première couche de matériau et la seconde couche de matériau étant faites de matériaux différents ; une surface de dessous de la couche supérieure (202) couvre complètement une surface de dessus de la couche inférieure (201), et une largeur de la surface de dessous de la couche supérieure (202) est plus grande qu'une largeur de la surface de dessus de la couche inférieure (201) dans un plan perpendiculaire à une direction d'extension des séparations de type bande (20),
**caractérisé en ce qu'**une de la seconde couche de matériau et de la première couche de matériau est faite d'un matériau de résine, et l'autre est faite d'un matériau isolant inorganique ; une épaisseur de la couche du matériau de résine est de 1,5 µm à 2 µm, et une épaisseur de la couche faite du matériau isolant inorganique est de 0,2 µm à 1 µm, et
la couche électroluminescente organique est mise en contact physiquement séparément avec les premières couches de matériau situées sur deux côtés de la couche électroluminescente organique.

2. Unité électroluminescente organique selon la revendication 1, dans laquelle une surface supérieure de la couche inférieure (201) est plus élevée qu'une surface supérieure de la seconde partie (302) de la seconde électrode (30).

3. Unité électroluminescente organique selon l'une quelconque des revendications 1 - 2, dans laquelle une section d'une couche empilée constituée par la couche supérieure (202) et la couche inférieure (201) est en symétrie axiale dans le plan perpendiculaire à une direction d'extension des séparations de type bande (20) .

4. Procédé de fabrication d'une unité électroluminescente organique, comprenant :
de former une première électrode (106) sur un substrat de base (10) ;
de former une première couche de matériau sur la première électrode (106) ;
de former une seconde couche de matériau et de réaliser le motif de la seconde couche de matériau pour obtenir une pluralité de premiers membres de type bande ;
de graver la première couche de matériau au moyen de la pluralité de premiers membres de type bande en tant qu'un masque pour obtenir une pluralité de seconde membres de type bande, de façon à permettre aux premiers membres de type bande et aux seconds membres de type bande qui sont empilés les uns avec les autres de constituer des séparations de type bande (20) ;
de former une couche électroluminescente organique (400) parmi les séparations de type bande (20) ; et
de former une seconde électrode (30) sur une surface du substrat de base (10), dans laquelle la seconde électrode (30) comprend une première partie (301) située sur une surface de chacune des séparations de type bande (20) et une seconde partie (302) située entre deux séparations de type bande (20) adjacentes,
dans laquelle la première couche de matériau et la seconde couche de matériau sont faites de matériaux différents ; dans un plan perpendiculaire à une direction d'exposition des séparations de type bande (20), une largeur d'une surface de dessous de la seconde couche de matériau est plus grande qu'une largeur d'une surface de dessus de la première couche de matériau, et la surface de dessous de la seconde couche de matériau couvre complètement la surface de dessus de la couche inférieure (201),
**caractérisé en ce qu'**une de la seconde couche de matériau et de la première couche de matériau est faite d'un matériau de résine, et l'autre est faite d'un matériau isolant inorganique ; une épaisseur de la couche du matériau de résine est de 1,5 µm à 2 µm, et une épaisseur de la couche faite du matériau isolant inorganique est de 0,2 µm à 1 µm, et
la couche électroluminescente organique est mise en contact physiquement séparément avec les premières couches de matériau situées sur deux côtés de la couche électroluminescente organique.

5. Procédé selon la revendication 4, dans laquelle la première couche de matériau est faite d'un matériau de résine et la seconde couche de matériau est faite d'un matériau isolant inorganique.

6. Procédé selon la revendication 5, comprenant en outre :
de former un film fin de résine (108) utilisé pour la première couche de matériau, et de former un film fin isolant inorganique (110) utilisé pour la seconde couche de matériau sur le film fin de résine (108) ;
de former une résine photosensible (112) sur le film fin isolant inorganique (110) et de former le motif de la résine photosensible par des procédés d'exposition et de développement pour exposer une partie du film fin isolant inorganique (110) ; et
de graver la partie exposée du film fin isolant inorganique (110) par un procédé de gravure à sec pour obtenir la pluralité de premiers membres de type bande (202') faits du matériau isolant inorganique.

7. Procédé selon la revendication 6, comprenant en outre :
avec la pluralité de premiers membres de type bande (202') en tant qu'un masque, de traiter le film fin de résine (108) par un procédé de calcination pour retirer simultanément une partie du film fin de résine (108) et la résine photosensible (112) résiduelle de façon à obtenir la pluralité de seconds membres de type bande (201') faits du matériau de résine.

8. Procédé selon la revendication 7, dans lequel dans le procédé de calcination, un gaz de calcination est un plasma d'oxygène.

9. Procédé selon la revendication 4, dans lequel la première couche de matériau est faite d'un matériau isolant inorganique, et la seconde couche de matériau est faite d'un matériau de résine.

10. Procédé selon la revendication 9, comprenant en outre :
de former un film fin isolant inorganique (114) utilisé pour la première couche de matériau, puis de former un film de résine fin (116) utilisé pour la seconde couche de matériau sur le film fin isolant inorganique (114) ; et
de former le motif du film de résine photosensible (116) par des procédés d'exposition et de développement pour obtenir la pluralité de premiers membres de type bande (202') faits du matériau de résine et exposer une partie du film fin isolant inorganique (114).

11. Procédé selon la revendication 10, comprenant en outre :
avec la pluralité de premiers membres de type bande (202') en tant qu'un masque, de graver le film fin isolant inorganique (114) exposé pour obtenir la pluralité de seconds membres de type bande (201') faits du matériau isolant inorganique.

12. Procédé selon l'une quelconque des revendications 9 - 11, dans lequel le matériau de résine est une résine photosensible.
